(19) Europäisches Patentamt
European Patent Office
Office européen des brevets

(11) Numéro de publication: 0 069 641 B1

(12) **FASCICULE DE BREVET EUROPEEN**

(45) Date de publication du fascicule du brevet: **13.11.85**

(51) Int. Cl.⁴: **C 08 L 49/00**, H 01 B 1/12, H 01 L 29/28, H 01 L 31/02

(21) Numéro de dépôt: **82401182.9**

(22) Date de dépôt: **25.06.82**

(54) **Matériau polyacétylène conducteur à grande stabilité, et son procédé de fabrication.**

(30) Priorité: **03.07.81 FR 8113157**

(43) Date de publication de la demande: **12.01.83 Bulletin 83/2**

(45) Mention de la délivrance du brevet: **13.11.85 Bulletin 85/46**

(84) Etats contractants désignés: **DE GB IT NL**

(56) Documents cités: **US - A - 4 204 216**

(73) Titulaire: **THOMSON-CSF, 173, Boulevard Haussmann, F-75379 Paris Cedex 08 (FR)**

(72) Inventeur: **Schue, François, THOMSON-CSF SCPI 173, bld Haussmann, F-75379 Paris Cedex 08 (FR)**
Inventeur: **Giral, Louis, THOMSON-CSF SCPI 173, bld Haussmann, F-75379 Paris Cedex 08 (FR)**
Inventeur: **Rolland, Michel, THOMSON-CSF SCPI 173, bld Haussmann, F-75379 Paris Cedex 08 (FR)**
Inventeur: **Aldissi, Mahmoud, THOMSON-CSF SCPI 173, bld Haussmann, F-75379 Paris Cedex 08 (FR)**
Inventeur: **Dubois, Jean-Claude, THOMSON-CSF SCPI 173, bld Haussmann, F-75379 Paris Cedex 08 (FR)**
Inventeur: **Gazard, Maryse, THOMSON-CSF SCPI 173, bld Haussmann, F-75379 Paris Cedex 08 (FR)**

(74) Mandataire: **Wang, Pierre et al, THOMSON-CSF SCPI 173, Bld Haussmann, F-75379 Paris Cedex 08 (FR)**

EP 0 069 641 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

BUNDESDRUCKEREI BERLIN

## Description

L'invention concerne le polyacétylène rendu conducteur par incorporation de dopant, et se présentant notamment sous forme de film (pellicule) flexible et mécaniquement résistant. L'invention englobe le procédé de fabrication et de dopage.

La demande de brevet européen publiée sous le N° 0 026 234 le 16 Octobre 1980 donne un procédé de fabrication d'un matériau dont la structure, présentant des fibres microcristallines, se prête bien à la fabrication de telles pellicules. Ce matériau comprend du polyacétylène à haut degré de polymérisation et au moins un dopant accepteur d'électrons tel que l'acide nitrique ou sulfurique ou un mélange d'acides forts, ou l'oxyde $S\,O_3$, un chlorure ou un bromure de bore, ou enfin un naphtoquinone éventuellement substitué à l'aide d'hydrogène, ou d'halogène ou d'un radical cyano, nitro, alkyle ou alkoxy. On obtient ainsi un matériau de conductivité pouvant varier de $10^{-9}\,ohm^{-1}\cdot cm^{-1}$ à $10^{3}\,ohm^{-1}\cdot cm^{-1}$, qui sous forme de pellicule, présente des caractéristiques acceptables de souplesse, tenue mécanique.

Il est également connu de fabriquer des films de polyacétylène rendu électriquement conducteur par incorporation d'un dopant comme l'enseigne le brevet américain US-A-4 204 216 déposé le 4 mai 1978. Dans ce cas, le dopant est un métal choisi selon sa valeur d'électronégativité, de préférence c'est un métal alcalin. Le dopage de ces films est obtenu à partir de sels de ces métaux.

Toutefois la conductivité ainsi obtenue n'est pas uniforme dans l'épaisseur du matériau et, en outre, disparaît rapidement avec le temps.

L'invention tend à supprimer ces inconvénients, en remplaçant les dopants classiques par des dopants à base d'éléments lourds qui présentent de faibles coefficients de diffusion.

L'invention a donc pour objet un matériau polyacétylène conducteur à grande stabilité thermique et à l'oxygène, le matériau étant rendu conducteur par incorporation d'un dopant, caractérisé en ce que le dopant est constitué d'un chlorure d'un élément appartenant soit à la famille des métaux de transition, soit à la famille des lanthanides.

Selon d'autres caractéristiques, les métaux de transition sont le chrome, le nickel, le fer, le titane, le tungstène et le molybdène et les lanthanides sont l'europium et l'ytterbium.

L'invention sera mieux comprise et les caractéristiques concernant le procédé de fabrication seront précisées, en se reportant à la description qui suit et aux dessins qui l'accompagnent, parmi lesquels:

La figure 1 représente le taux de dopage en fonction du temps de dopage proprement dit dans deux réalisations de l'invention;

La figure 2 représente les conductivités obtenues en fonction de la quantité de dopant dans les mêmes réalisations;

La figure 3 donne des caractéristiques comparées de stabilité dans le temps, dans le cas de l'invention et dans celui d'un dopant classique.

Dans la description qui suit, on utilisera la notation habituelle pour la formulation du polyacétylène dopé par un composé X:

$$(CH\,X_y)_x$$

dans laquelle y sera désigné comme le taux de dopage ou concentration en moles du dopant.

On décrit d'abord ci-après les étapes préliminaires de préparation de la pellicule de polyacétylène.

a) On prépare deux solutions de catalyseurs, par exemple le tétrabutoxytitane, $(C_4\,H_9O)_4\,Ti$, d'une part, et, d'autre part, de triéthylaluminium, $(C_2\,H_5)_3\,Al$, pour constituer, par mélange, un amorceur de polymérisation du type Ziegler-Natta. Le solvant peut être le toluène dans l'exemple choisi, la quantité de soluté étant de 0,006 à 0,1 mole/l. On introduit successivement les deux solution dans le ballon d'un réacteur comportant des moyens de faire le vide. Un dégazage a lieu par pompage après chaque introduction de liquide.

b) Le mélange est laissé sous vide partiel dans le réacteur, placé à la température ambiante, pendant au moins vingt minutes. Puis on refroidit le mélange à —78°C en plaçant le ballon dans un mélange de méthanol et de neige carbonique à l'état solide. On introduit de l'acétylène à une pression comprise entre 30 et 700 mm de mercure dans le réacteur. Il se produit alors à la surface de la solution une couche de polymère dont l'épaisseur dépend de la pression et de la durée d'admission d'acétylène. Cette couche constitue le film de polyacétylène que l'on dégaze et que l'on lave à une température comprise entre —78°C et 0°C à l'aide de toluène ou de pentane jusqu'à ce que le solvant de lavage devienne incolore. On sèche ensuite le film sous vide poussé puis on le place dans un tube que l'on scelle sous vide.

L'étape propement dite de fabrication par dopage du matériau recherché comporte les sous-étapes suivantes; on a pris comme exemple le cas d'un chlorure utilisé comme dopant, tel que $W\,Cl_6$ ou $Mo\,Cl_5$.

1°) Le dopant est mis sous vide dans un ballon relié directement au tube contenant le film, puis dégazé sous vide secondaire;

2°) Le solvant, par exemple du toluène, est introduit par distillation dans le ballon contenant le dopant, qui est refroidi pour condenser le toluène. Le volume du solvant est calculé en fonction du poids de dopant de

façon à obtenir une concentration prédéterminée, faible, par exemple 0,1 g/l ou moins.

3°) Le système, constitué par le ballon contenant la solution et le tube contenant le film est ensuite isolé de la pompe à vide et la solution est transvasée par gravité dans le tube contenant le film.

4°) On laisse le dopage se poursuivre pendant une durée de l'ordre de plusieurs jours, soit une semaine environ à la température ambiante. Cette durée est nécessaire pour obtenir un dopage uniforme dans l'épaisseur de la pellicule de polyacétylène. Pour que le dopage soit uniforme, il faut en effet que la cinétique de dopage soit faible et par conséquent opérer à basse température et en solution diluée de l'espèce dopante. Le taux de dopage obtenu dépend de la concentration du dopant dans le solvant, la quantité de solution admise dans le tube contenant le film étant supposée suffisante.

5°) La solution dopante est ensuite retransvasée dans le ballon et le film est lavé plusieurs fois par le solvant introduit dans le tube par condensation afin d'éliminer l'excès de dopant se trouvant sur la surface du film.

6°) On procède au sèchage du film par pompage sous vide.

Sur la figure 1, on a porté en abscisse le logarithme du temps de dopage exprimé en seconds et en ordonnées le taux de dopage y du polyacétylène $(CH\,X_y)x$.

Les courbes 1 et 2 représentent les variations de ce taux, respectivement dans le cas du dopant $W\,Cl_6$ et du dopant $Mo\,Cl_5$. On voit que plusieurs jours ($10^5$ à $10^6$ secondes) sont nécessaires pour amener le taux de dopant au dessus de 0,05.

Sur la figure 2, on a tracé la courbe de conductivité (en $ohm^{-1} \cdot cm^{-1}$) en fonction du taux de dopant. Les courbes 21 et 22 correspondent aux cas respectifs de $W\,Cl_6$ et $Mo\,Cl_5$. On remarque que la variation de conductivité est très sensible au taux de dopage entre 0 et 0,05 puis devient beaucoup moins sensible à partir d'une valeur de 0,05 pour le taux et de 10 $ohm^{-1} \cdot cm^{-1}$ pour la conductivité.

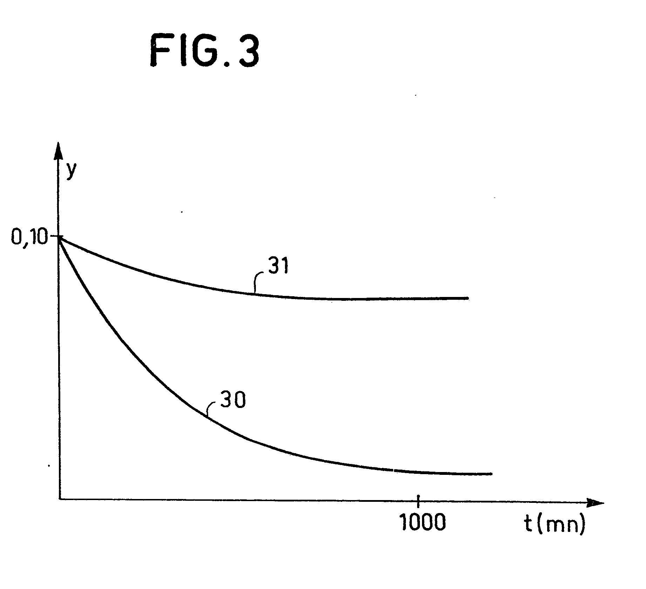

Sur la figure 3, on a dessiné la décroissance du taux de dopant à 120°C et sous vide le temps étant porté en minutes, dans le cas de $Mo\,Cl_5$ (courbe 31) et de l'iode (courbe 30). Ce dernier cas est en dehors de l'invention.

On constate que, pour l'iode, une diminution très forte du taux de dopage a lieu au bout de quelques heures, avec une stabilité à un taux très bas.

Au contraire, dans le cas de l'invention, la diminution est faible et la stabilisation a lieu à un taux de l'ordre de 0,8.

Le matériau selon l'invention peut être utilisé, selon sa conductivité, soit comme conducteur organique, soit comme semiconducteur de type p, soit seul, soit en combinaison avec un semiconducteur de type n. Il est applicable à la réalisation de photodiodes et de piles solaires.

## Revendications

1. Matériau polyacétylène conducteur à grande stabilité, thermique et à l'oxygène, le matériau étant rendu conducteur par incorporation d'un dopant, caractérisé en ce que le dopant est constitué d'un chlorure d'un élément appartenant soit à la famille des métaux de transition, soit à la famille des lanthanides.

2. Matériau selon la revendication 1, caractérisé en ce que le métal de transition est le chrome, le nickel, le fer, le titane, le tungstène ou le molybdène.

3. Matériau selon la revendication 1, caractérisé en ce que l'élément de la famille des lanthanides est l'europium ou l'ytterbium.

4. Procédé de fabrication d'un matériau selon l'une des revendications 1 à 3, caractérisé en ce qu'il comprend au moins les étapes suivantes consistant à:

A) Dans un ensemble comprenant un premier récipient contenant le matériau sous forme de polymère et un deuxième récipient contenant une solution de dopant, transvaser sous vide, par gravité, la solution du deuxième récipient dans le premier, et maintenir l'ensemble dans cet état à la température ambiante pendant une durée de plusieurs jours;

B) lavages du film par le solvant introduit dans le premier récipient par condensation.

5. Procédé selon la revendication 4, caractérisé en ce qu'il est précédé des étapes préliminaires suivantes, consistant à:

a) Préparer un mélange constituant un amorceur de polymérisation du type Ziegler-Natta;

b) Le mélange étant maintenu sous vide dans un récipient à basse température, introduire de l'acétylène à une pression comprise entre 30 et 700 mm de mercure, pendant une durée prédéterminée en fonction de l'épaisseur de la pellicule de polyacétylène à obtenir;

c) Dégazer la pellicule de polyacétylène, laver celle-ci, la dégaze par pompage sous vide et la placer en tube scellé sous vide.

6. Procédé selon la revendication 4, caractérisé en ce que, le dopant étant $W\,Cl_6$ ou $Mo\,Cl_5$, au cours d'une étape préliminaire on prépare dans un ballon une solution de chlorure à faible concentration de l'ordre de 0,1 g/l:

a) Préparer un mélange constituant un amorceur de polymérisation du type Ziegler-Natta;

b) Le mélange étant maintenu sous vide dans

un récipient à basse température, introduire de l'acétylène à une pression comprise entre 30 et 700 mm de mercure, pendant une durée prédéterminée en fonction de l'épaisseur de la pellicule de polyacétylène à obtenir;

c) Dégazer la pellicule de polyacétylène, laver celle-ci, la dégazer par pompage sous vide et la placer en tube scellé sous vide.

7. Procédé selon la revendication 5, caractérisé en ce que, le dopant étant W $Cl_6$ ou Mo $Cl_5$, au cours d'une étape préliminaire on prépare dans un ballon une solution de chlorure à faible concentration de l'ordre de 0,1 g/l de toluène et on met le ballon en communication avec un récipient contenant le matériau sous forme de polymère.

## Patentansprüche

1. Leitfähiges Material aus Polyazetylen, das thermisch und gegen Sauerstoff sehr stabil ist und durch Einfügung eines Dotiermittels leitend gemacht ist, dadurch gekennzeichnet, daß das Dotiermittel von dem Chlorid eines Elements gebildet wird, das entweder der Familie der Übergangsmetalle oder der Familie der Lanthaniden angehört.

2. Material nach Anspruch 1, dadurch gekennzeichnet, daß das Übergangsmetall aus der Gruppe ausgewählt wird, die Chrom, Nickel, Eisen, Titan, Wolfram und Molybdän enthält.

3. Material nach Anspruch 1, dadurch gekennzeichnet, daß das Element aus der Familie der Lanthaniden Europium oder Ytterbium ist.

4. Verfahren zur Herstellung eines Materials nach einem der Ansprüche 1 bis 3, dadurch gekennzeichnet, daß es mindestens die folgenden Verfahrensschritte enthält:

A) In einer Anordnung bestehend aus einem ersten das Material in Polymerform enthaltenden Behälter und einem zweiten eine Lösung des Dotiermittels enthaltenden Behälter wird unter Vakuum durch Schwerkraft die im zweiten Behälter enthaltene Lösung in den ersten Behälter hinübergeschüttet, worauf das Ganze in diesem Zustand bei Umgebungstemperatur während der Dauer mehrerer Tage gehalten wird;

B) der Film wird mit dem Lösungsmittel gewaschen, das in den ersten Behälter durch Kondensation eingeführt wurde.

5. Verfahren nach Anspruch 4, dadurch gekennzeichnet, daß folgende Verfahrensschritte vorangestellt werden:

a) Eine Mischung wird vorbereitet, die einen Auslöser für die Polymerisation vom Typ Ziegler-Natta bildet;

b) die Mischung wird unter Vakuum in einen Behälter bei niederer Temperatur gehalten, und dann wird Azetylen bei einem Druck zwischen 30 und 700 mm Quecksilber während einer vorgegebenen Zeitdauer abhängig von der gewünschten Dicke der Polyazetylenfolie eingeführt;

c) die Polyazetylenfolie wird entgast, gewaschen, wobei die Entgasung durch Evakuierung und Einbringen in ein unter Vakuum versiegeltes Rohr erfolgt.

6. Verfahren nach Anspruch 4, dadurch gekennzeichnet, daß bei der Wahl von $WCl_6$ oder $MoCl_5$ als Dotiermittel während eines vorgeschalteten Schritts in einem Ballon eine Chloridlösung mit niedriger Konzentration in der Größenordnung von 0,1 g/l vorbereitet wird:

a) Eine einen Polymerisationsauslöser bildende Mischung vom Typ Ziegler-Natta wird vorbereitet;

b) die Mischung wird in einem Behälter unter Vakuum bei niederer Temperatur gehalten, und Azetylen wird mit einem Druck zwischen 30 und 700 mm Quecksilber während einer vorgegebenen Zeit abhängig von der Dicke der gewünschten Polyazetylenfolie eingeführt;

c) die Polyazetylenfolie wird entgast, gewaschen, entgast durch Evakuierung und in einem unter Vakuum versiegelten Rohr untergebracht.

7. Verfahren nach Anspruch 5, dadurch gekennzeichnet, daß bei der Wahl von $WCl_6$ oder $MoCl_5$ als Dotiermittel während eines vorgeschalteten Verfahrensschrittes in einem Ballon eine Chloridlösung mit niedriger Konzentration in der Größenordnung von 0,1 g/l Toluol vorbereitet wird und der Ballon mit einem das in Polymerform vorliegende Material enthaltenden Behälter in Verbindung gebracht wird.

## Claims

1. A conductive polyacetylene material with a high thermal stability and stability to oxygen, wherein said mateial is made conductive by incorporating a dopant, characterized in that the dopant is constituted by a chloride of an element belonging either to the family of the transition metals or to the family of lanthanides.

2. A material according to claim 1, characterized in that the transition metal is selected from the group consisting of chrome, nickel, iron, titanium, tungsten and molybdenum.

3. A material according to claim 1, characterized in that the element belonging to the family of lanthanides is europium or ytterbium.

4. A method for amnufacturing a material according to one of claims 1 to 3, characterized in that it comprises at least the following steps:

A) In an assembly comprising a first container including the material in the polymer state

and a second container including a solution of the dopant, the solution included in the second container is poured under vacuum conditions by gravity into the first container, the assembly remaining in this state at ambient temperature for several days;

B) the film is washed by the solvant introduced into the first container by condensation.

5. A method according to claim 4, characterized in that it is preceded by the following preliminary steps:

a) A mixture constituting an initiator of polymerization of the Ziegler-Natta type is prepared;
b) the mixture is maintained under vacuum in a container at low temperature and acetylene is introduced at a pressure between 30 and 700 mm mercury for a predetermined duration depending on the desired thickness of a polyacetylene film;
c) the polyacetylene film is degazed, washed, degazed by pumping under vacuum and placed in a vacuum tight tube.

6. A method according to claim 4, characterized in that the dopant being $WCl_6$ or $MoCl_5$, a chloride solution of low concentration rate of about 0,1 g/l is prepared during a preliminary step in a flask:

a) A mixture constituting an initiator of polymerization of the Ziegler-Natta type is prepared;
b) the mixture being kept under vacuum in a container at low temperature, acetylene is introduced at a pressure between 30 and 700 mm mercury during a predetermined duration depending on the desired thickness of the polyacetylene film;
c) the polyacetylene film is degazed, washed, degazed by pumping under vacuum and placed in a vacuum tight tube.

7. A method according to claim 5, characterized in that the dopant being $WCl_6$ or $MoCl_5$, a chloride solution of low concentration of about 0,1 g/l of toluene is prepared in a flask during a preliminary step and the flask is made to communicate with a container including the material in the polymer state.

FIG.1

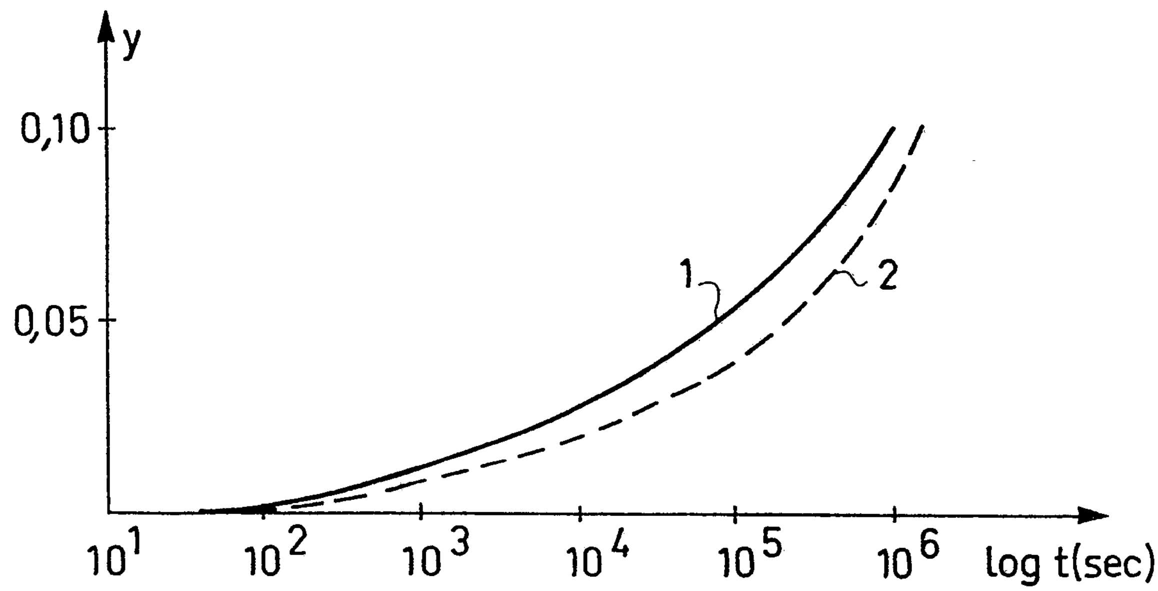
y
0,10
0,05
1
2
$10^1$
$10^2$
$10^3$
$10^4$
$10^5$
$10^6$
log t(sec)

FIG. 2

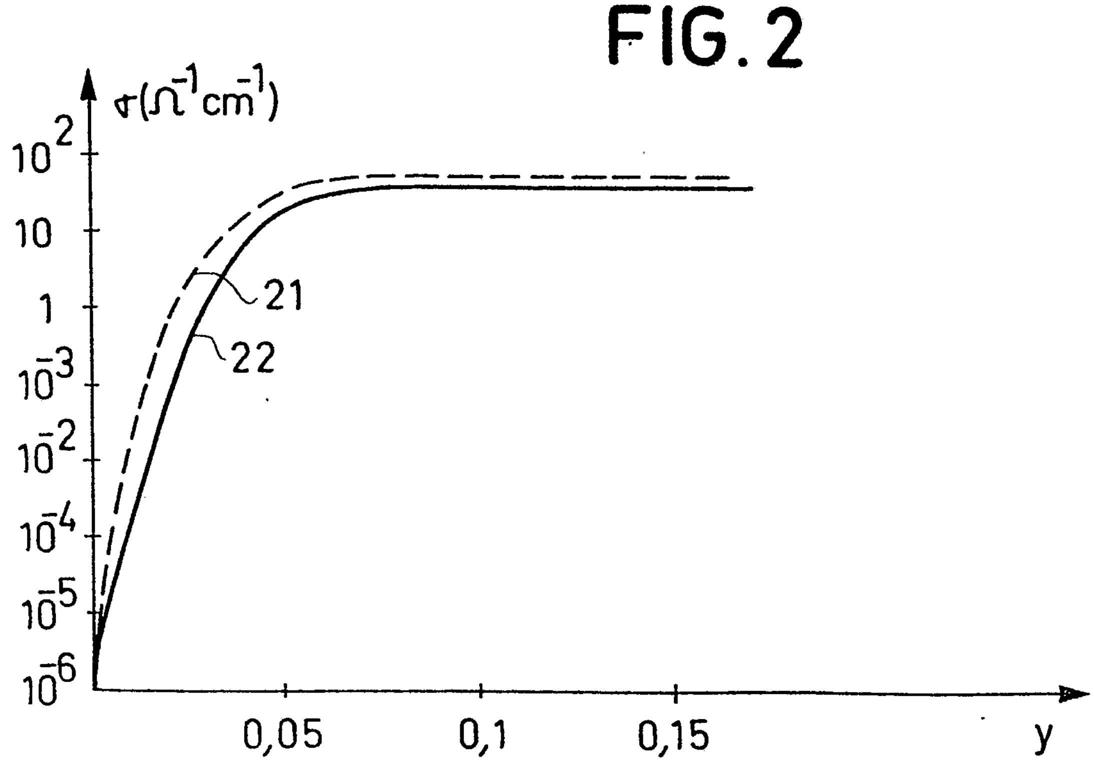
σ(Ω⁻¹cm⁻¹)
$10^2$
10
1
$10^{-3}$
$10^{-2}$
$10^{-4}$
$10^{-5}$
$10^{-6}$
21
22
0,05
0,1
0,15
y

FIG. 3